(19) Europäisches Patentamt
European Patent Office
Office européen des brevets

(11) **EP 1 406 095 B1**

(12) **EUROPEAN PATENT SPECIFICATION**

(45) Date of publication and mention
of the grant of the patent:
**07.05.2008 Bulletin 2008/19**

(51) Int Cl.:
*H02P 23/14* (2006.01)   *G01R 19/00* (2006.01)
*G05F 1/575* (2006.01)

(21) Application number: **03016549.2**

(22) Date of filing: **24.07.2003**

(54) **Electric current detector and motor driving device using the same**

Stromdetektor und Motorantriebsvorrichtung unter Verwendung dieses Detektors

Détecteur de courant et dispositif d'entraînement de moteur l'utilisant

(84) Designated Contracting States:
**ES IT**

(30) Priority: **02.10.2002   JP 2002290069**

(43) Date of publication of application:
**07.04.2004 Bulletin 2004/15**

(73) Proprietor: **MATSUSHITA ELECTRIC INDUSTRIAL CO., LTD**
**Kadoma-shi, Osaka 571-8501 (JP)**

(72) Inventors:
• **Maeda, Shiro**
**Otsu-shi,**
**Shiga 520-2101 (JP)**
• **Harada, Kazuhiro**
**Kusatsu-shi,**
**Shiga 525-0057 (JP)**
• **Noma, Hirofumi**
**Shiga 520-0232 (JP)**
• **Arakawa, Masashi**
**Kusatsu-shi,**
**Shiga 525-0058 (JP)**

(74) Representative: **Kügele, Bernhard et al**
**Novagraaf International SA,**
**25, avenue du Pailly**
**1220 Les Avanchets - Geneva (CH)**

(56) References cited:
WO-A-97/50162           JP-A- 8 034 359
US-A- 5 204 594         US-A- 5 945 853
US-B1- 6 278 255

**Description**

**TECHNICAL FIELD**

The present invention relates to an electric current detector in a control system having only the positive DC supply source (viz. a control system of single supply source), which electric current detector being structured simple and capable of detecting electric current flowing both the positive and the negative directions. The present invention also discloses a rationalized motor driving device which incorporates the electric current detector.

**BACKGROUND ART**

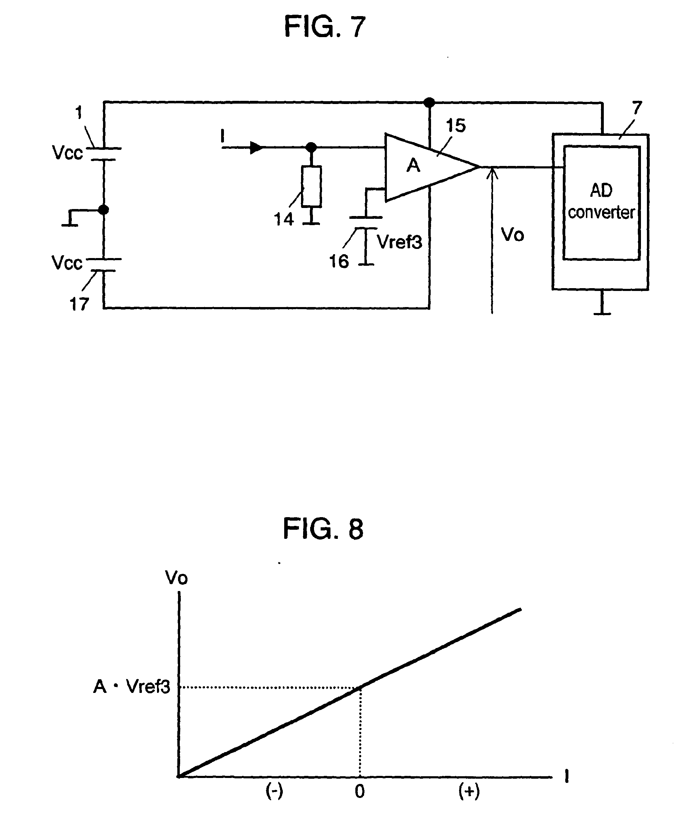

For the purpose of detecting an electric current flowing in a line, it has been a generally practiced method to insert a current detection resistor in the line and check a voltage drop caused by the current flowing in the resistor. In this method of detection, if the current to be detected flows in both directions, the voltage drop at the current detection resistor is exhibited in both the positive and negative polarities. Therefore, the signal processing circuit for current detection needs to be capable of handling signals of both the positive and negative polarities. An example of such circuit as shown in FIG. 7 is described below.

FIG. 7 shows a circuit for measuring current I that flows between current detection resistor 14 and the ground in both the positive and negative directions. The circuit is formed of positive DC supply source 1, negative DC supply source 17, microcomputer 7 having an AD conversion function operating on positive DC supply source 1, current detection resistor 14, arithmetic adder 15 operating on positive DC supply source 1 and negative DC supply source 17, and reference voltage 16 for adjusting the output voltage level of arithmetic adder 15. The value of reference voltage 16 is exhibited as Vref3. The operation is described in the below.

Current I to be detected flows to the ground via current detection resistor 14 in both the positive and the negative directions. When current I is flowing in the direction as indicated with an arrow mark in the drawing, the voltage incoming to arithmetic adder 15 is positive; whereas, when it is flowing in the opposite direction, the voltage incoming to arithmetic adder 15 is negative. Therefore, arithmetic adder 15 needs to be provided with supply sources of both the positive and negative polarities; positive DC supply source 1 and negative DC supply source 17.

Value of output Vo from arithmetic adder 15 is judged by microcomputer 7. Since microcomputer 7 is operating on positive DC supply source 1 (the voltage is Vcc), input thereto, or the output Vo from arithmetic adder 15, needs to bear a positive value, from 0 to Vcc. Therefore, arithmetic adder 15 adjusts the value of output Vo by adding the voltage Vref3 of reference voltage 16 to the voltage drop caused at current detection resistor 14.

FIG. 8 is a graph used to describe relationship between the current I and the output Vo in the circuit diagram shown in FIG. 7. In FIG. 8, the lateral axis represents the current I, while the longitudinal axis the output Vo. Assuming gain of arithmetic adder 15 as A, the relationship between output value Vo and current I is represented by the straight oblique line. If the current I is zero, for example, it signifies that only reference voltage 16 is applied on arithmetic adder 15; then, output Vo from arithmetic adder 15 is (A . Vref3). Namely, the positive output Vo is made available to the current I of both the positive and negative directions. Above-described method has been taught in publications; for example, "Designing OP Amplifier Circuits" by Michio Okamura (1973, CQ Publishing Co., Ltd.).

The document US 5,204,594 shows a current detecting circuit according to the preamble of the independent claim 1. Particularly, this U.S. patent discloses a circuit for providing a signal proportional to the average current supplied to the coils of a motor operated in both linear and PWM modes, which includes a sense resistor across which a voltage representing the current flowing supplied to said coils is developed. The voltage is selectively applied to an output circuit which operates as a low pass filter circuit when drive current is supplied to the coils and as a voltage hold circuit when drive current is not supplied to the coils.

Although this known circuit is capable of handling signals of both the positive and negative polarities, it needs a rather complex switch circuit operating in response to PWM signals to disconnect the sense resistor voltage from the amplifier, when drive current is not supplied to the coils to operate as a voltage hold circuit.

The technical problem underlying the present invention is to provide a current detector for an electric motor control system, which needs a single DC supply source, shows a simple topology and is capable of handling current signals exhibiting both positive and negative polarities.

**DISCLOSURE OF THE INVENTION**

An electric current detector in the present invention includes;
a positive DC supply source,
a first resistor, a second resistor and a third resistor connected in series in this order, and
differential amplifying means, which is supplied from the positive DC supply source, for calculating the difference of voltage at connection point of the first resistor and the second resistor from certain specific voltage; in which
the third resistor is forming at least part of the current route in which the current to be detected flows, the current to be detected being supplied to the connection point between the second resistor and the third resistor
the first resistor is connected at the terminal which is not connected with the second resistor to the positive DC supply source,
the third resistor is grounded at the terminal which is not connected with the second resistor, and
resistance values of the first resistor, second resistor and third resistor and the certain specific voltage have been set so that the constant term in arithmetic formula corresponding to the transfer function of the differential amplifying means turns out to be positive.

A motor driving device in the present invention includes;
the above-described electric current detector,
a second DC supply source having the negative pole (ground) in common with the positive DC supply source,
a group of semiconductor switches, which is supplied from the second DC supply source, formed of a plurality of units of semiconductor switches and diodes connected inverse-parallel in the bridge arrangement,
driving means for driving the group of semiconductor switches,
a motor connected with the output end of semiconductor switch group, and
comparative means for comparing a voltage generated at the third resistor with a second specific voltage, and delivering the output to the driving means; in which
the current flowing between the negative DC line of the semiconductor switch group and the negative pole (ground) of the second DC supply source being the target of detection, and the third resistor is forming at least part of the current route in which the current flows.

## BRIEF DESCRIPTION OF THE DRAWINGS

FIG. 1 shows a structure in accordance with a first exemplary embodiment of the present invention.
FIG. 2 is a characteristics chart of the first embodiment.
FIG. 3 shows a practical structure of the first embodiment.
FIG. 4 shows a structure in accordance with a second exemplary embodiment of the present invention.
FIG. 5 shows a practical structure of the second embodiment.
FIG. 6 shows a structure in accordance with a third exemplary embodiment of the present invention.
FIG. 7 shows a structure of a conventional example.
FIG. 8 is a characteristics chart of a conventional example.

## DETAILED DESCRIPTION OF THE PREFERRED EMBODIMENTS

The present invention is described in accordance with some of the exemplary embodiments referring to the drawings.

(Embodiment 1)

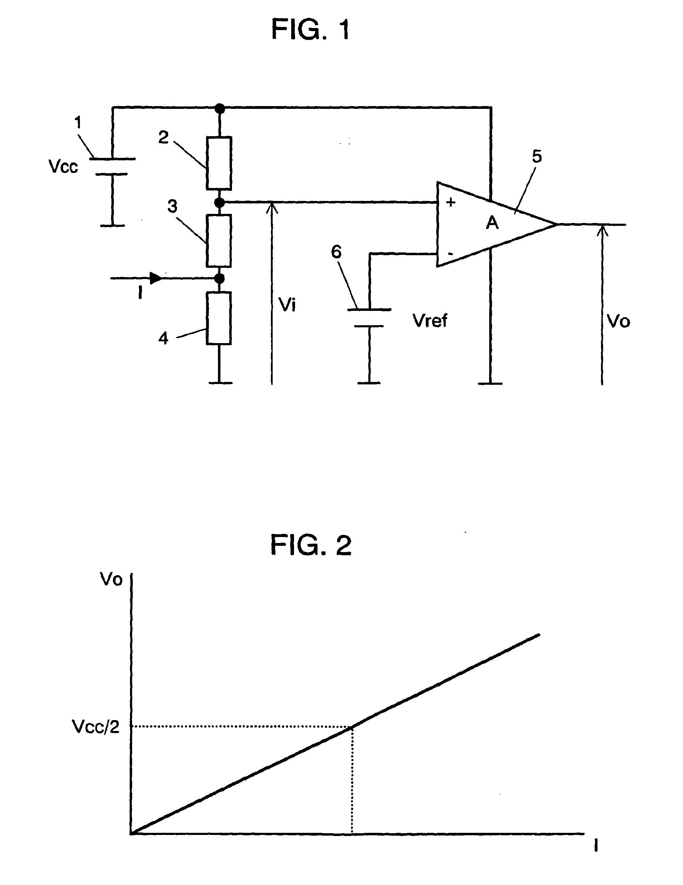

FIG. 1 shows structure of an electric current detector in accordance with a first embodiment of the present invention. First resistor 2, second resistor 3 and third resistor 4 are connected in series in the order. Among the two terminals of first resistor 2, the one not connected with second resistor 3 is connected to the positive end of DC supply source 1. Voltage of DC supply source 1 is Vcc. Among the two terminals of third resistor 4, the one not connected with second resistor 3 is grounded.

Current I to be detected is supplied to the connection point between second resistor 3 and third resistor 4. Namely, third resistor 4 forms the route of current I, and third resistor 4 plays the role of current detection resistor. Differential amplifying means 5 is supplied from positive DC supply source 1. The positive input terminal of differential amplifying means 5 receives a voltage at the connection point between first resistor 2 and second resistor 3. While the negative input terminal of differential amplifying means 5 receives certain specific voltage 6 as the reference. Potential of certain specific voltage 6 is Vref. The output of differential amplifying means 5 is identical to output of an electric current detector.

A differential amplifier, an arithmetic amplifier, an amplifier circuit which generates positive gain to an input signal delivered at one input terminal and negative gain to an input signal delivered at the other input terminal, or such other amplifiers can be used for differential amplifying means 5.

FIG. 2 is characteristics chart of the current detector of FIG. 1; which chart shows relationship between current I to be detected, and output Vo of current detector. In FIG. 2, the lateral axis represents current I, while the longitudinal axis representing output Vo from differential amplifying means 5. The oblique straight line signifies the relationship between I and Vo. FIG. 2 will be detailed later once again.

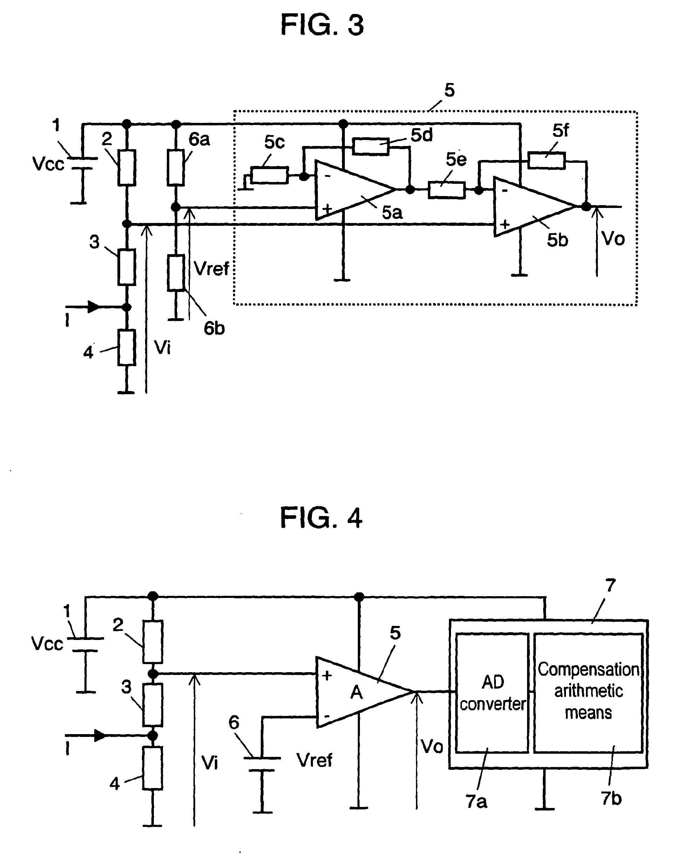

FIG. 3 shows the structure of FIG. 1 from a more practical point of view. In the drawing, those portions identical to those of FIG. 1 are not described here. Differential amplifying means 5 is formed of arithmetic amplifier 5a, arithmetic amplifier 5b, resistor 5c, resistor 5d, resistor 5e and resistor 5f. Arithmetic amplifier 5a and arithmetic amplifier 5b are supplied from DC supply source 1. Resistor 6a and resistor 6b are connected in series. Among the two terminals of resistor 6a, the one not connected with resistor 6b is connected to positive DC supply source 1. Among the two terminals of resistor 6b, the one not connected to resistor 6a is grounded. The voltage at connection point between resistor 6a and resistor 6b is certain specific voltage 6. Namely, the voltage at connection point between resistor 6a and resistor 6b is Vref.

In the first place, operation of the structure shown in FIG. 1 is described. Output voltage Vo from differential amplifying means 5 is given by (formula 1); where, voltage applied to the positive input terminal of differential amplifying means 5 is Vi, gain at differential amplifying means 5 is A :

$$Vo = A \cdot (Vi - Vref) \qquad \text{(formula 1)}$$

Defining respective values of first resistor 2, second resistor 3 and third resistor 4 as R1, R2 and R3, respectively; the above Vi is given as (formula 2) :

$$Vi = (R2 + R3) \cdot Vcc / (R1 + R2 + R3)$$
$$+ R1 \cdot R3 \cdot I / (R1 + R2 + R3) \qquad \text{(formula 2)}$$

From (formula 1) and (formula 2), the output voltage Vo is given as (formula 3):

$$Vo = A \cdot [ (R2 + R3) \cdot Vcc / (R1 + R2 + R3) - Vref ]$$
$$+ A \cdot R1 \cdot R3 \cdot I / (R1 + R2 + R3) \qquad \text{(formula 3)}$$

The first term in (formula 3) is constant term, and it is possible to select R1, R2, R3, Vcc and Vref so that the constant term takes positive value.

By selecting the relevant values so that the first term of (formula 3) becomes Vcc / 2, the relationship between current I and output voltage Vo is exhibited by an oblique straight line as shown in FIG. 2. Thus, the positive output voltage Vo can be made available against current I of both the positive and negative directions. If current I is zero, for example, Vo is Vcc / 2. Furthermore, since the constant has been selected to make the first term of (formula 3) is Vcc / 2, it turned out to be possible to detect the electric current for the same range in both the positive and negative directions. In practice, each of the constants is selected so that output voltage Vo falls within an allowable variation range (0 - Vcc) against variable range of current I to be detected in both the positive and negative directions.

Now, more practical description is made with reference to FIG. 3. The values of resistors 5c, 5d, 5e, 5f, 6a and 6b are represented as R4, R5, R6, R7, R8 and R9, respectively. Assuming respective values of R4 and R7, as well as R5 and R6, to be the same, characteristics of differential amplifying means 5 shown in FIG. 3 are given by (formula 4) :

$$Vo = A \cdot (Vi - Vref) = (1 + R4 / R5) \cdot (Vi - Vref) \qquad \text{(formula 4)}$$

Certain specific voltage 6, or the reference voltage, (Vref) is represented by (formula 5) :

$$Vref = Vcc \cdot R9 / (R8 + R9) \qquad \text{(formula 5)}$$

With the structure and operation as described in the above, an electric current detector whose characteristics are identical to those of FIG. 2 is implemented.

(Embodiment 2)

FIG. 4 shows structure of an electric current detector in accordance with a second embodiment of the present invention. Those portions identical to those of FIG. 1 are not described here. Compensation means 7 compensates errors included in the output Vo from differential amplifying means 5. Compensation means 7 has AD conversion function and compensation arithmetic function. Compensation means 7 of the example shown in FIG. 4 includes AD converter 7a and compensation arithmetic means 7b. Compensation means 7 is supplied from the above-mentioned positive DC supply source 1, and the allowable input range is (0 - Vcc) positive.

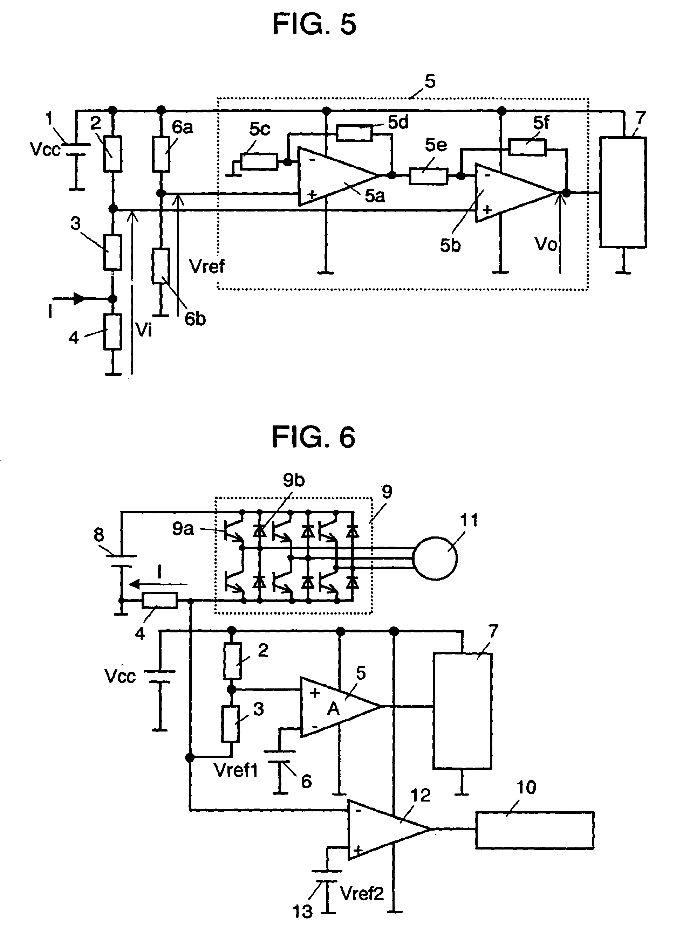

FIG. 5 illustrates the above described structure from more practical point of view. The structure shown in FIG. 5 is that of FIG. 3 added with a microcomputer as compensation means 7. The rest remains the same as in FIG. 3; so, description on the identical portions is eliminated. The operation is described below referring to FIG. 5.

As described earlier in the above, the output voltage Vo from differential amplifying means 5 is given by the (formula 4), the Vi included in the formula is given by the (formula 2), and the Vref by the (formula 5).

The Vo is given by the (formula 4), as described earlier, on condition that respective R4 and R7, and R5 and R6, are made to be the same values. In reality, however, each of the respective resistors includes errors. Therefore, in the strict sense, the output voltage Vo is not given by the (formula 4), but it contains errors.

By the same token, the Vcc value of positive DC supply source 1, as well as the value Vref of certain specific voltage 6, contain errors. So, although each of the constants has been selected to make the first term of (formula 3) to be Vcc / 2 in embodiment 1, it is also affected by the error. The microcomputer as compensation means 7 stores in the memory the difference Voff, which being difference between output voltage Vo of differential amplifying means 5 when the current I is zero and the ideal value Vcc / 2 at zero error with the above-described constants. And then, the microcomputer as the compensation means 7 deducts the Voff from output voltage of differential amplifying means 5 when the current I is flowing. Thus the errors contained in the first term of (formula 3) can be compensated.

Although a microcomputer has been used for compensation means 7 in the above description, it is not limited to the microcomputers. Other circuits or processors can be used instead for compensation means 7, in so far as they can memorize the difference Voff and deduct it from output voltage of differential amplifying means 5 when the current I is flowing.

(Embodiment 3)

FIG. 6 shows structure of a motor driving device in accordance with a third exemplary embodiment of the present invention. Second DC supply source 8 is for driving motor 11, the negative pole of which supply source shares common potential (ground potential) with the negative pole of positive DC supply source 1. Group of semiconductor switches 9 is consisting of six units. Each of the units is formed of power transistor 9a as a semiconductor switch, and diode 9b connected in adverse-parallel. The adverse-parallel connection refers to a parallel connection where power transistor 9a and diode 9b are connected in parallel so that the direction of their conductive currents is opposite to each other. The six units of semiconductor switch group 9 constitute three-phase bridge. The DC input end of three-phase bridge is connected with second DC supply source 8, while the AC output end is connected to motor 11.

Resistor 4 is connected between the negative DC line of semiconductor switch group 9 and the negative pole (ground) of second DC supply source 8, and constituting part of the above-described electric current detector. Descriptions on those portions identical to those of the electric current detectors in embodiment 1 or 2 are eliminated here.

In the present embodiment, value of the earlier-described certain specific voltage 6 is exhibited as Vref1. Comparator 12 is used as the comparative means here. Comparator 12 as the comparative means is supplied from the positive DC supply source 1. The voltage at connection point between second resistor 3 and third resistor 4 is inputted to the negative terminal of comparator 12, while second specific voltage 13 which corresponds to the value of allowable current at semiconductor switch group 9 is inputted to the positive terminal of comparator 12. Second specific voltage 13 is Vref2 Output of comparator 12 is delivered to driving means 10. Driving means 10 drives six power transistors 9a of semiconductor switch group 9.

Operation of the above-described structure is described below. Driving means 10 generates drive signals for driving semiconductor switch group 9. While motor 11 is driven as the result of operation of semiconductor switch group 9, a certain electric current which is relevant to the current running in motor 11 flows through third resistor 4. The certain electric current can take the positive and the negative directions depending on operating state of motor 11. By detecting the certain current with an electric current detector as described in embodiments 1, 2, load size of motor 11 can be watched continuously. Driving means 10 generates appropriate drive signals in accordance with the detection results, and motor 11 is driven in a stable manner.

The voltage drop at third resistor 4 due to current I to be detected is compared by comparator 12 with second specific voltage 13 (Vref2). As soon as the voltage drop exceeds beyond the above-mentioned specific voltage 13 (Vref2), comparator 12 reverses the output to discontinue the drive signal of driving means 10. Since specific voltage 13 (Vref2) has been set at voltage which corresponds to the value of allowable current at semiconductor switch group 9, the circuit under discussion can detect the over current in semiconductor switch group 9 at high speed, and prevent it.

Although comparator 12 is used for the comparative means in the above description, it is not limited to comparator 12. The comparative means is for comparing the voltage at connection point between second resistor 3 and third resistor 4 with second specific voltage 13, and supply control signals to driving means 10 in accordance with the results of comparison. So, the comparative means can be formed instead with an arithmetic circuit, a logic circuit, a differential amplifier, an arithmetic amplifier, a processor, etc., in so far as it can perform the above functions.

As described in the above, the present invention makes it possible to form a motor driving device employing positive DC supply source 1 alone; which motor driving device detects the current of motor 11 running in the both directions for continuously watching loads on motor 11 in order to drive motor 11 appropriately, and at the same time functions as a protection device by cutting the over current at semiconductor switch group 9 at high speed. Furthermore, the current detection resistor is used in common in the present invention, so it facilitates efficiency improvement, down sizing and cost reduction with the devices.

As described in the above, a system of electric current detection which can detect electric current flowing both the positive and negative directions employing the positive DC supply source alone, without needing the negative DC supply source, is implemented by using an electric current detector and a motor driving device in accordance with the present invention.

Furthermore, in an electric current detector and a motor driving device in the present invention, the errors generated at respective elements constituting the detector can be compensated for a substantial magnitude. Thereby, a high precision bidirectional current detection can be performed by employing the positive DC supply source alone, without adding a dedicated compensation circuit. Thus it facilitates to implement a high precision current detector and motor driving device in a smaller size and at lower cost.

Furthermore, in an electric current detector and a motor driving device in the present invention, detection of motor current which is needed for controlling the motor, and the current detection at semiconductor switch group which is needed for protection control of the semiconductor switch group are performed by a single current detection resistor; and such a system can be structured with only the positive DC supply source. Thus it facilitates the efficiency improvement, precision level improvement, down sizing and cost cutting with the electric current detectors and the motor driving devices.

**Claims**

1. An electric current detector comprising:

   a positive DC supply source (1);
   a first resistor (2), a second resistor (3) and a third resistor (4) connected in series in this order; and
   differential amplifying means (5), which is supplied from said positive DC supply source (1), for calculating the difference of voltage (Vi) at connection point of said first resistor (2) and said second resistor (3) from a certain specific voltage (Vref),
   **characterised in that** said third resistor (4) is forming at least part of current route in which the current to be detected flows, said current to be detected being supplied to the connection point between said second resistor (3) and said third resistor (4),
   said first resistor (2) is connected to said positive DC supply source at a terminal which is not connected with said second resistor (3),
   said third resistor (4) is grounded at a terminal which is not connected with said second resistor (3), and
   resistance values of said first resistor (2), said second resistor (3) and said third resistor (4) and said certain specific voltage have been set so that the constant term in the arithmetic formula corresponding to the transfer function of said differential amplifying means turns out to be positive.

2. The electric current detector of claim 1, further comprising
   compensation means (7) which deducts Voff, which being the difference between the actual output value of said differential amplifying means (5) when said current to be detected is zero and the ideal output value at zero error with constituent elements, from output value of said differential amplifying means (5) generated while said current to be detected is flowing; which compensation means (7) being supplied from said positive DC supply source (1).

3. A motor driving device comprising:

   the electric current detector of claim 1 or claim 2;
   a second DC supply source (8) having a negative pole (ground) in common with said positive DC supply source (1);
a group of semiconductor switches (9), which being supplied from said second DC supply source (8), formed of a plurality of units consisting of semiconductor switches (9a) and diodes (9b) connected inverse-parallel in bridge arrangement;
driving means (10) for driving said group of semiconductor switches (9);
a motor (11) connected to output terminal of said group of semiconductor switches (9); and
comparative means (12) for comparing voltage generated at said third resistor (4) with second specific voltage, and delivering the output to said driving means (10),
wherein said current to be detected is electric current which flows between the negative DC line of said semiconductor switch group (9) and the negative pole (ground) of said second DC supply source (8), and said third resistor (4) forms at least part of electric current route in which said current to be detected flows.

## Patentansprüche

1. Elektrischer-Strom-Detektor mit:

einer Positiver-Gleichstrom-Quelle (1);
einem ersten Widerstand (2), einem zweiten Widerstand (3) und einem dritten Widerstand (4), die in dieser Reihenfolge in Reihe geschaltet sind; und
Differenzverstärkungsmitteln (5), die von der Positiver-Gleichstrom-Quelle (1) gespeist werden, zum Berechnen der Differenz einer Spannung ($V_i$) an einem Anschlusspunkt des ersten Widerstands (2) und des zweiten Widerstands (3) zu einer bestimmten festgelegten Spannung ($V_{ref}$),

**dadurch gekennzeichnet, dass**
der dritte Widerstand (4) zumindest einen Teil des Strompfads bildet, in dem der zu detektierende Strom fließt, wobei der zu detektierende Strom in den Anschlusspunkt zwischen dem zweiten Widerstand (3) und dem dritten Widerstand (4) eingespeist wird,
der erste Widerstand (2) mit der Positiver-Gleichstrom-Quelle an einem Anschluss verbunden ist, der nicht mit dem zweiten Widerstand (3) verbunden ist,
der dritte Widerstand (4) an einem Anschluss geerdet ist, der nicht mit dem zweiten Widerstand (3) verbunden ist, und
Widerstandswerte des ersten Widerstands (2), des zweiten Widerstands (3) und des dritten Widerstands (4) und die bestimmte festgelegte Spannung so eingestellt worden sind, dass der konstante Term in der arithmetischen Formel, die der Übertragungsfunktion in den Differenzverstärkungsmitteln entspricht, positiv wird.

2. Elektrischer-Strom-Detektor nach Anspruch 1, der weiterhin Kompensationsmittel (7) aufweist, die $V_{off}$, die die Differenz zwischen dem tatsächlichen Ausgangswert der Differenzverstärkungsmittel (5) für den Fall, dass der zu detektierende Strom null ist, und dem idealen Ausgangswert bei einem Nullpunktfehler mit den Bauelementen ist, von dem Ausgangswert der Differenzverstärkungsmittel (5) abziehen, der entsteht, während der zu detektierende Strom fließt, wobei die Kompensationsmittel (7) von der Positiver-Gleichstrom-Quelle (1) gespeist werden.

3. Motorantriebsvorrichtung mit:

dem Elektrischer-Strom-Detektor nach Anspruch 1 oder Anspruch 2;
einer zweiten Gleichstromquelle (8), die einen negativen Pol (Erde) mit der Positiver-Gleichstrom-Quelle (1) gemeinsam hat;
einer Halbleiterschaltergruppe (9), die von der zweiten Gleichstromquelle (8) gespeist wird und von mehreren Einheiten gebildet wird, die aus Halbleiterschaltern (9a) und Dioden (9b) bestehen, die antiparallel in Brückenanordnung geschaltet sind;
Ansteuermitteln (10) zum Ansteuern der Halbleiterschaltergruppe (9);
einem Motor (11), der mit einem Ausgangsanschluss der Halbleiterschaltergruppe (9) verbunden ist; und
Vergleichsmitteln (12) zum Vergleichen der an dem dritten Widerstand (4) erzeugten Spannung mit der zweiten festgelegten Spannung und zum Senden des Ausgangssignals an die Ansteuermittel (10),

**dadurch gekennzeichnet, dass** der zu detektierende Strom ein elektrischer Strom ist, der zwischen der Negativer-Gleichstrom-Leitung der Halbleiterschaltergruppe (9) und dem negativen Pol (Erde) der zweiten Gleichstromquelle (8) fließt, und der dritte Widerstand (4) zumindest einen Teil des Pfads des elektrischen Stroms bildet, in dem der zu detektierende Strom fließt.

**Revendications**

1. Détecteur de courant électrique comprenant:

   une source d'alimentation de courant continu positif (1);
   une première résistance (2), une deuxième résistance (3) et une troisième résistance (4) connectées en série dans cet ordre; et
   un moyen d'amplification différentiel (5), qui est alimenté à partir de ladite source d'alimentation de courant continu positif (1), pour calculer la différence de tension (Vi) à un point de connexion de ladite première résistance (2) et de ladite deuxième résistance (3) à partir d'une certaine tension spécifique (Vref),
   **caractérisé en ce que** ladite troisième résistance (4) forme au moins une partie du chemin du courant dans lequel le courant à détecter circule, ledit courant à détecter étant alimenté au point de connexion entre ladite deuxième résistance (3) et ladite troisième résistance (4),
   ladite première résistance (2) est connectée à ladite source d'alimentation de courant continu positif au niveau d'une borne qui n'est pas connectée avec ladite deuxième résistance (3),
   ladite troisième résistance (4) est mise à la terre au niveau d'une borne qui n'est pas connectée avec ladite deuxième résistance (3), et
   les valeurs de résistance de ladite première résistance (2), de ladite deuxième résistance (3) et de ladite troisième résistance (4) et de ladite certaine tension spécifique ont été établies de sorte que le terme constant dans la formule arithmétique correspondant à la fonction de transfert dudit moyen d'amplification différentiel se trouve être positif.

2. Détecteur de courant électrique de la revendication 1, comprenant en plus
   un moyen de compensation (7) qui déduit Voff, qui est la différence entre la valeur de sortie effective dudit moyen d'amplification différentiel (5) lorsque ledit courant à détecter est nul et la valeur de sortie idéale à erreur nulle avec des éléments constituants, à partir de la valeur de sortie dudit moyen d'amplification différentiel (5) générée pendant que ledit courant à détecter circule; lequel moyen de compensation (7) étant alimenté à partir de ladite source d'alimentation de courant continu positif (1).

3. Dispositif d'entrainement de moteur comprenant:

   le détecteur de courant électrique de la revendication 1 ou de la revendication 2;
   une deuxième source d'alimentation de courant continu (8) ayant un pôle négatif (terre) en commun avec ladite source d'alimentation de courant continu positif (1);
   un groupe de commutateurs à semi-conducteurs (9), qui sont alimentés à partir de ladite deuxième source d'alimentation de courant continu (8), formés d'une pluralité d'unités se composant de commutateurs à semi-conducteurs (9a) et de diodes (9b) connectés en parallèle inverse dans un agencement de pont;
   un moyen d'entrainement (10) pour entrainer ledit groupe de commutateurs à semi-conducteurs (9);
   un moteur (11) connecté à une borne de sortie dudit groupe de commutateurs à semi-conducteurs (9); et
   un moyen de comparaison (12) pour comparer une tension générée au niveau de ladite troisième résistance (4) avec une deuxième tension spécifique, et délivrer la sortie audit moyen d'entraînement (10),
   où ledit courant à détecter est un courant électrique qui circule entre la ligne de courant continu négatif dudit groupe de commutateurs à semi-conducteurs (9) et le pôle négatif (la terre) de ladite deuxième source d'alimentation de courant continu (8), et ladite troisième résistance (4) forme au moins une partie du chemin du courant électrique dans lequel ledit courant à détecter circule.

# FIG. 1

# FIG. 2

# FIG. 3

# FIG. 4

## FIG. 5

## FIG. 6

# FIG. 7

# FIG. 8

**EP 1 406 095 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 5204594 A

**Non-patent literature cited in the description**

• **MICHIO OKAMURA.** Designing OP Amplifier Circuits. CQ Publishing Co., Ltd, 1973